# EUROPEAN PATENT APPLICATION

(11) **EP 4 579 754 A1**
(43) Date of publication of application: **02.07.2025**
(21) Application number: 23383396.1
(22) Date of filing: 28.12.2023
(51) Int. Cl.: H01L 29/06, H10K 10/46, H10K 85/20, B81C 1/00

(54) **NANOELECTROMECHANICAL DEVICES COMPRISING A CARBON NANOTUBE AND METHODS OF MANUFACTURING**

(71) Applicant: Ideaded, S.L., 08840 Viladecans (ES)
(72) Inventor: PARMAR, Jemish Mahendrabhai, 08840 Viladecans (ES); ALBAREDA PIQUER, Guillermo, 08840 Viladecans (ES); URGELL OLLÉ, Núria, 08840 Viladecans (ES)
(74) Representative: Bardehle Pagenberg S.L.

(57) **Abstract**

The present disclosure relates to a device comprising a substrate, a first electrode on the substrate, which is configured as either a source or a drain of the device and a second electrode on the substrate, which is configured as the other of the source and the drain of the device. The device further comprises a carbon nanotube with a first end connected to the first electrode and a second end connected to the second electrode, a mid-section of the carbon nanotube being suspended above a surface of the substrate. The device also comprises one or more third electrodes arranged above the carbon nanotube and configured as top gates capacitively coupled to the carbon nanotube, wherein an empty space exists between a top part of the carbon nanotube and a bottom part of the third electrodes. The present disclosure further comprises a method for the manufacture of such device.

## Description

The present disclosure relates to nanoelectromechanical devices comprising carbon nanotubes and to methods of manufacturing the same.

### BACKGROUND

Nanoelectromechanical systems (NEMS) are devices featuring electrical and mechanical capabilities at nanoscale dimensions. As technology evolves to increasing miniaturization, NEMS devices represent a step from the Microelectromechanical systems (MEMS) devices into the nanoscale regime. Physics at the nanoscale differ from physics at the microscale and quantum effects become dominant in the physical behavior of the devices. This opens the possibility for new device concepts and applications such as, e.g. quantum computing and quantum simulation. Nevertheless, selection of appropriate materials and fabrication of devices at the nanoscale come with their own challenges. In particular, low yields and high device quality variability are commonly observed with current processing technologies.

Carbon-based materials are among the preferred materials for the manufacture of NEMS devices as they exhibit mechanical, electrical and electromechanical properties that are well suited to the requirements of NEMS devices. Carbon can form multiple allotropes, such as diamond, graphite, amorphous carbon, graphene or carbon nanotubes (CNTs). Carbon nanotubes are particularly promising for the fabrication of different NEMS with a wide range of applications. Carbon nanotubes can be understood as basically cylinders obtained by rolling up graphene sheets. On the one hand, single-walled carbon nanotubes (SWCNTs) comprise a single cylinder, which typically exhibits diameters in the nanometer range. The length of the SWCNTs may vary depending on, e.g. the manufacturing technique, and may range from several nanometers to several micrometers (µm). On the other hand, Multi-walled carbon nanotubes (MWCNTs) comprise a plurality of nested cylinders. CNTs exhibit different properties depending on the way the sheet of graphene is rolled up. Furthermore, CNTs can be classified as metallic or semiconducting depending on their electronic properties.

Carbon nanotubes have exceptional crystallinity, which results in remarkable mechanical properties such as extremely high tensile strength. Furthermore, the nanostructure of CNTs results also in exceptional thermal conductivity and electronic conductivity. Based on their extraordinary properties, devices based on carbon nanotubes can be used for different applications such as supercapacitors, field effect transistors, sensors or quantum bits (qubits).

Due to their nanoscale dimensions, CNTs are one-dimensional (1D) objects and they confine electrons in 1D. A CNT quantum dot (QD) is formed when electrons are confined to a small region within a carbon nanotube. This is normally accomplished when a single CNT is connected between two electrodes by application of a voltage to a number of gate electrodes. In such situations, electrons can be confined in a zero-dimensional (0D) potential well with discrete energy levels. Additionally, one or more quantum dots can be defined at one or more locations along a carbon nanotube by electrostatic gating, i.e. by arranging one or more gates capacitively coupled to the CNT at different locations so that the electrostatic potential at said different locations can be fine-tuned so as to create single or multiple quantum dots.

In some cases, carbon nanotubes (CNTs) can be used in a suspended arrangement. Thus, the ends of a carbon nanotube can be connected at respective electrodes while the mid-section is left hanging, i.e. unsupported. In this case, vibrations can be induced in the CNT, which can then act as a resonator, by, e.g. an electrostatic forced exerted by a gate.

As mentioned, structures comprising CNTs can be used as qubits in quantum computing applications. A qubit is a two-level quantum system that constitutes a basic unit of information in quantum computing. Multiple types of qubits can be defined making use of the different properties of carbon nanotubes and depending on the arrangement of the carbon nanotube in the system. Thus, a quantum dot (QD) can be created by connecting a single CNT between two electrodes and configuring one or more gate electrodes along the length of the CNT. A QD is then formed in the mid-section of the carbon nanotube, i.e. in the section of the carbon nanotube between the two electrodes. An electron may be physically confined in the quantum dot and quantum information may be encoded in, e.g. the spin of the confined electron, thus producing a so-called spin qubit.

Charge-based qubits comprising carbon nanotubes have been also proposed. Different types of charge-based qubits can be envisaged. For instance, a system can be defined in which two quantum dots (QDs) are formed in a CNT arranged between two electrodes. To this end, a plurality of gates can be capacitively coupled to the CNT at different positions along the length of the CNT. In particular, the number and arrangement of the gates can be selected so that two QDs are formed and are separated by a tunnel barrier. Accordingly, a charge qubit can be defined based on the excess or presence of electrons in one quantum dot with respect to another quantum dot.

Further examples of CNT-based qubits comprise the use of carbon nanotubes in nanomechanical qubits. Thus, a suspended CNT can be used as a nanomechanical resonator with two or more quantized energy levels.

Quantum dots placed along a vibrating nanotube provide a quantum simulation platform that can directly address the electron-phonon interaction.

Nanoelectromechanical systems (NEMS) comprising carbon nanotubes can also be used for other applications such as sensors for small masses and forces, or field effect transistors. In the latter case, a semiconducting carbon nanotube can be used as the transistor channel.

Regardless of the specific application, most NEMS devices involving use of carbon nanotubes comprise the connection of the ends of the carbon nanotube to respective electrodes, and the definition of one or more gates capacitively coupled to the carbon nanotube. The fabrication of such devices is divided into three main categories: bottom gating, top gating and mechanical transfer.

Bottom gating involves growing or depositing the carbon nanotubes on electrodes that are prefabricated on a substrate. The prefabricated electrodes act as the end contacts for the carbon nanotube and also as the gates. This technique suffers from some drawbacks. One of those drawbacks relates to the quality of the contact, which is limited as the carbon nanotube is simply lying on top of the electrodes and the contact area can be very small. Even more importantly, bottom gating fabrication processes generally exhibit very low yield, as obtaining working devices relies on the chance to obtain a single carbon nanotube, with the desired properties, lying at the precise location. In particular, lying at a location wherein the carbon nanotube is only contacting, at each of its ends, a first and a second electrode, i.e. a source and a drain electrode.

Top-gating involves fabricating the electrodes, including one or more gate electrodes, on top of carbon nanotubes, which are previously provided on a substrate. An insulating material, e.g. an oxide, is typically disposed between the carbon nanotube and the gate in the regions where they overlap. In this manner, capacitive coupling is enabled and a short circuit is prevented. Top-gating fabrication processes also exhibit some limitations. In particular, patterning and etching steps are needed to define the electrodes, i.e. the source, drain and gate of the devices. In doing so, damage can be induced on the already deposited carbon nanotubes. Additionally, top-gated devices keep the carbon nanotube buried in, or at least in contact with, an insulating material. This contact is known to affect the properties of the carbon nanotube due to charge fluctuations resulting from the presence of charge traps in the insulating material. Furthermore, the presence of the insulating material in contact with the carbon nanotube is an impediment for certain applications, e.g. use of the flexural modes of the carbon nanotube in a nanomechanical qubit.

The third category for the fabrication processes comprises mechanical transfer. In this case, handling of individual carbon nanotubes is carried out. Hence, carbon nanotubes are transferred to the corresponding electrodes, which are predefined on a substrate. The individual handling and transfer permits a highly controllable and precise placement. Furthermore, this method allows selection of specific carbon nanotubes and results in clean structures. Nevertheless, the handling of carbon nanotubes is challenging and it can easily induce damage that can affect the electromechanical properties of the transferred carbon nanotubes.

In examples of the present disclosure improved nanoelectromechanical (NEMS) devices comprising carbon nanotubes are provided. Furthermore, in examples of the present disclosure manufacturing methods that reduce at least some of the aforementioned drawbacks are provided.

### SUMMARY

In an aspect of the present disclosure, a nanoelectromechanical device based on a carbon nanotube is provided. The device comprises a substrate, a first electrode and a second electrode. The first electrode is on the substrate and it is configured as either a source or a drain of the device. The second electrode is also on the substrate and it is configured as the other of the source and the drain of the device. The device further comprises a carbon nanotube with a first end connected to the first electrode and a second end connected to the second electrode, at least a portion of a mid-section of the carbon nanotube being suspended above a surface of the substrate. One or more third electrodes are arranged above the carbon nanotube, the third electrodes being configured as top gates capacitively coupled to the carbon nanotube. An empty space exists between a top part of the carbon nanotube and a bottom part of at least one of the top gates.

According to this aspect, a device with improved capabilities is presented. A fully suspended carbon nanotube (CNT) can be provided when the whole mid-section is suspended above a surface of the substrate.. In other words, the device can be configured so that the carbon nanotube is hanging between end contacts established with the first and second electrode and no further support is provided between the carbon nanotube and the substrate. By preventing contact with the substrate, reduced uncertainty at the interface between the CNT and the substrate is obtained, thus improving device performance. Furthermore, affectation of the CNT properties resulting from charge fluctuations in the substrate are also avoided.

One or more top gates are arranged in proximity of the carbon nanotube so that they are capacitively coupled to it. Accordingly, the top gates are configured to induce a controllable electrostatic potential in the carbon nanotube. The arrangement, e.g. the number and location, and controllability of the top gates provides enhanced flexibility to the device, which can be configured for different applications.

Furthermore, the top gates are disposed above the carbon nanotube but, at least one of them is disposed without any physical contact. In other words, at least one of the top gates overlaps the mid-section of the carbon nanotube, i.e. the section of the carbon nanotube that is not connected to the first and second electrodes, but no direct or indirect physical contact is established between the carbon nanotube and that specific top gate. An empty space thus exists between a top part of the carbon nanotube and a bottom part of this specific third electrode configured as top gate such that the corresponding top gate is in floating configuration. This physical separation prevents charge fluctuations that would result from the presence of charge traps in the material, e.g. oxide, disposed between the carbon nanotube and the gates in previously existing devices. Thus, the absence of any direct contact with the suspended section of the carbon nanotube can result in increased electron mobility and, consequently, increased electrical conductivity through the carbon nanotube.

Moreover, the separation of the carbon nanotube from both the one or more top gates and from the substrate allows the exploitation of the mechanical properties of the carbon nanotube. This separation enables the utilization of the flexural modes of the carbon nanotube, thus opening the possibility to store quantum information and use the device as a nanomechanical qubit.

In particular, in a situation wherein an empty space is provided between a top part of the carbon nanotube and a bottom part of all the top gates, the flexural modes of the carbon nanotube may correspond to the flexural modes of the complete length of the mid-section of the carbon nanotube. In other examples, as mentioned before, a physical contact may be established between the carbon nanotube and or more of the top gates. Such physical contact may allow splitting the flexural modes of the carbon nanotube.

In a further aspect of the disclosure, a method of manufacturing a device according to the previous aspect is provided. The method comprises providing the substrate and providing a first insulating layer on the substrate. A plurality of carbon nanotubes are provided on the first insulating layer. The method further comprises detecting at least one carbon nanotube of the plurality of carbon nanotubes and identifying longitudinal ends of the detected carbon nanotube. A second insulating layer is deposited on the first insulating layer and at least on the detected carbon nanotube. The method then comprises exposing the longitudinal ends of the detected carbon nanotube by etching the first and the second insulating layers in an area surrounding each of the longitudinal ends. A conductor is deposited in the etched areas to define the first electrode and the second electrode, the conductor contacting the longitudinal ends of the carbon nanotube. A conductor is also deposited on the second insulating layer in a region overlapping the mid-section of the carbon nanotube to form the one or more third electrodes, which are configured as top gates. Finally, the method comprises etching the first insulating layer and the second insulating layer in at least a portion of an area between the first electrode and the second electrode and along the length of the carbon nanotube.

According to examples of this further aspect of the disclosure, a method of manufacturing a MEMS device comprising a gate-controlled, suspended or fully suspended, carbon nanotube is provided.

The method according to this further aspect is such that the electrodes are fabricated after detection of the carbon nanotubes. In this manner, individual carbon nanotubes with desired properties, e.g. length or shape, can be selected. Afterwards, specific electrodes are fabricated for individually selected carbon nanotubes. This manufacturing process offers a high yield, and eliminating dependence on chance, which is characteristic of some of the commonly used process, particularly of those involving bottom gating.

Furthermore, the top gate structures are fabricated after provision of the carbon nanotubes so that they do not need to endure the harsh conditions of carbon nanotube growth, which may exist in other manufacturing methods. In this manner, gate material constraints are relaxed with respect to some of the previously existing methods.

A further advantage of this aspect is that the fabrication method provides higher scalability and automation than other fabrication methods such as those involving mechanical handling and transfer of individual carbon nanotubes. Thus, the methods according to this disclosure can be carried out with automated nanotube location and with automatic etching and patterning procedures for the formation of the different electrodes.

Throughout this disclosure, the mid-section of a carbon nanotube is to be understood as the section of the carbon nanotube that is not connected to the first and second electrodes. In other words, the mid-section refers to the portion of the carbon nanotube that extends between the first and second electrodes.

Furthermore, throughout this disclosure, different electrodes are mentioned, which are configured for different uses. Thus, the term first electrode(s) refers to the contact electrode(s) configured as either a source or a drain of the device, whereas the term second electrode(s) refers to the contact electrode(s) configured as the other of the source or the drain of the device. Moreover, the term third electrode(s) refers to the top gate electrode(s) configured as top gates of the device whereas the term fourth electrode(s) refers to the bottom gate electrode(s) configured as bottom gates of the device.

### BRIEF DESCRIPTION OF THE DRAWINGS

Non-limiting examples of the present disclosure will be described in the following, with reference to the drawings, in which:
Figure 1 schematically illustrates a side view of a nanoelectromechanical device comprising a carbon nanotube according to an example of the disclosure;
Figure 2 shows a flowchart of an example method of manufacturing a nanoelectromechanical device comprising a carbon nanotube;
Figures 3A - 3G schematically illustrate top and cross-sectional (A-A') views at different stages of an example method for manufacturing a nanoelectromechanical device comprising a carbon nanotube;
Figures 4A - 4E schematically illustrate side views of a nanoelectromechanical device comprising a carbon nanotube and a bottom gate according to different examples of the disclosure;
Figures 5A - 5B schematically illustrate side views of a nanoelectromechanical device comprising a carbon nanotube in which physical contact is provided between the carbon nanotube and either a top gate (Figure 5a) or a bottom gate (Figure 5B).

### DETAILED DESCRIPTION OF EXAMPLES

Reference will now be made in detail to embodiments, one or more examples of which are illustrated in the drawings. Each example is provided by way of explanation only, not as a limitation. In fact, it will be apparent to those skilled in the art that various modifications and variations can be made in the present disclosure. It is intended that the present disclosure covers such modifications and variations as come within the scope of the appended claims and their equivalents. Furthermore, drawings are intended to illustrate the different examples and manufacturing process. For the sake of clarity, dimensions of the different elements are not at scale to facilitate identification of the different components.

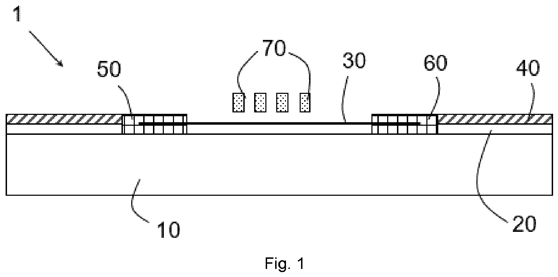

Figure 1 is a side view of a nanoelectromechanical device 1 comprising a carbon nanotube 30 according to an example. The device 1 comprises a substrate 10, a first electrode 50 and a second electrode 60. The first electrode 50 is arranged on the substrate 10 and it is configured as either a source or a drain of the device 1. The second electrode 60 is also arranged on the substrate 10 and it is configured as the other of the source and the drain of the device 1.

The device 1 further comprises a carbon nanotube 30 with a first end connected to the first electrode 50 and a second end connected to the second electrode 60, a mid-section of the carbon nanotube 30 being suspended above a surface of the substrate 10. One or more third electrodes 70 are arranged above the carbon nanotube 30, the third electrodes 70 being configured as top gates capacitively coupled to the carbon nanotube 30. An empty space exists between a top part of the carbon nanotube 30 and a bottom part of the third electrodes 70.

Thus, according to this example, the whole mid-section is suspended above a surface of the substrate 10. Furthermore, an empty space exists between a top part of the carbon nanotube 30 and a bottom part of all the third electrodes 70 in this example and no physical contact of the carbon nanotube 30 with any of the third electrodes 70 configured as top gates is provided. Accordingly, a device 1 with a fully suspended carbon nanotube 30 may be provided which may comprise no support between the mid-section of the carbon nanotube 30 and the substrate 10 along the whole mid-section.

The provision of an empty space between a top part of the carbon nanotube 30 and a bottom part of the third electrodes 70, which are configured as top gates of the device 1, allows the utilization of the mechanical properties of the carbon nanotube 30. Thus, the one or more top gates may be configured to induce a vibration of the carbon nanotube 30, such that the device 1 may be configured as a nanomechanical qubit. In particular, in this example, the vibration may be induced along the whole mid-section of the carbon nanotube 30.

Furthermore, the physical separation of the mid-section of the carbon nanotube 30 from the substrate 10 and from the third electrodes 70 may prevent charge fluctuations that may result from interaction with charge traps at either the substrate 10 and/or the third electrodes 70. The position of such floating top gates and a fully suspended carbon nanotube 30 may also enhance the electron mobility in the carbon nanotube 30. This aspect may be particularly useful in some applications. Thus, the device 1 may be configured as a field effect transistor, more specifically wherein the carbon nanotube 30 may be configured as a channel of the field effect transistor and the top gates may be configured as a gate contact of the field effect transistor.

In examples of the present disclosure, the carbon nanotube 30 may extend substantially along a longitudinal direction from the first electrode 50 to the second electrode 60. The device may comprise a plurality of third electrodes 70 arranged above the carbon nanotube 30, which may be configured as a plurality of top gates. The third electrodes 70 may be arranged at different positions along the longitudinal direction and along the mid-section of the carbon nanotube 30. Specifically, in examples of the disclosure, three or more third electrodes 70 may be provided. More specifically, five third electrodes 70 may be provided.

The provision of multiple third electrodes 70, i.e. the provision of multiple top gates, may facilitate certain applications by allowing control of electrostatic field at selected locations of (i.e. here, different longitudinal positions along) the carbon nanotube 30. In particular, said controllability may permit the definition of different quantum dots (QDs) along the length of the carbon nanotube 30. Thus, QDs may be formed in the carbon nanotube 30 by the electrostatic potentials generated by the plurality of third electrodes 70. By adjusting the voltages of the top gates, the position and sizes of the QDs may be modified. Consequently, the device 1 may be configured as a qubit. Thus, the one or more top gates may be configured to define one or more quantum dots in the carbon nanotube 30 and the device 1 may configured as a spin qubit and/or as a charge qubit.

In an example of the present disclosure, five top gates, i.e. five third electrodes 70, may be provided above the mid-section of the carbon nanotube 30 along the longitudinal direction of the carbon nanotube 30. In this manner, a double quantum dot (DQD) may be obtained. More particularly, the third electrode 70, i.e. the top gate, that is arranged closest to the first electrode 50 may be used to control the voltage barrier between the corresponding first electrode 50 and the first quantum dot whereas the third electrode 70 that is arranged closest to the second electrode 60 may be used to control the voltage barrier between the second electrode 60 and the second quantum dot of the DQD. Then, the three third electrodes 70 arranged between the two end third electrodes 70, i.e. between the two end top gates, may be used to control the tunnel coupling between the quantum dots (QDs) in the DQD.

In examples of the present disclosure, an arrangement may be provided to prevent bending of the suspended carbon nanotube 30. Thus, a rigid configuration of the carbon nanotube 30 may be preferred for some applications not relying on the flexural degrees of freedom of the carbon nanotube 30. In particular, when using the device 1 as a, e.g. spin qubit or charge qubit, a substantially rigid carbon nanotube 30 may be advantageous to prevent interference or undesired coupling between different degrees of freedom. In this manner, a cleaner or purer device 1 may be obtained. Furthermore, the provision of a rigid configuration may also be advantageous to enhance structural and mechanical stability of the device 1. Different approaches may be used to increase the stiffness of the carbon nanotube 30. In an example, the device may comprise a coating material, specifically an oxide, arranged wrapping the mid-section of the carbon nanotube 30.

Figure 1 depicts a device 1 wherein a single carbon nanotube 30 is arranged between the first electrode 50 and the second electrode 60. Nevertheless, in examples of the disclosure, multiple carbon nanotubes 30 may be arranged in parallel. They may be connected between the first electrode 50 and the second electrode 60 with the mid-section of the multiple carbon nanotubes 30 suspended above a surface of the substrate 10.

The use of a plurality of carbon nanotubes 30 may be advantageous in some applications. Thus, when using the device 1 as a field effect transistor, the number of carbon nanotubes 30 may be modified to tune the conductivity of the channel of the transistor.

The dimensions of the device 1, and of its different parts, may be defined by the application of the device 1 and/or by the manufacturing method. In an example of the disclosure, the third electrodes 70 may have a thickness of between 1 nm and 100 µm and a width of between 1 nm and 10 µm.

The dimensions of the third electrodes 70 may be defined, not only in view of the intended final functionality of the device 1, but also in view of the mechanical and structural stability of the device 1. More particularly, as shown in Figure 1, the third electrodes 70 may be arranged in a floating configuration so that they may be hanging with a suspended section arranged above, but not in physical contact with, the carbon nanotube 30. In order to improve mechanical stability of that hanging portion, a certain thickness of the material making up the third electrodes 70 may be desired.

The length of the carbon nanotubes 30 provided on the substrate 10 is related to the main dimensions of the device 1 and it may vary over a very wide range in accordance with circumstances.

Thus, in examples of the disclosure, the distance between the first electrode 50 and the second electrode 60 may lie between 3 nm and 100 µm. Indeed, the length of the carbon nanotube 30 used for the fabrication of the device 1 may be selected in view of the foreseen application or implementation. Furthermore, the length of the carbon nanotube 30 may also be influenced by the method used for the provision of the carbon nanotubes 30.

In some applications, including the use of the device 1 as a nanomechanical device, vibration of the suspended carbon nanotube 30 may be used and tuning of vibrational modes of the carbon nanotube 30 may be based on its length. In other applications, such as when using the device 1 as a field effect transistor, a short length of the carbon nanotube 30 may be preferred as this may correspond to a short length of the channel of the field effect transistor, thus improving the performance, e.g. the speed, of the device 1.

As already mentioned, the device 1 shown in Figure 1 is characterized by a suspended carbon nanotube 30 and a plurality of third electrodes 70, which are capacitively coupled but not in physical contact (either direct or indirect physical contact) with the carbon nanotube 30. Thus, the third electrodes 70 are in a floating-like configuration. In examples of the disclosure, the distance of the carbon nanotube 30 with respect to top surface of the substrate 10 and with respect to the bottom part of the third electrodes 70 may be designed to fulfill the specific needs of the intended application.

In an example, the distance between the mid-section of the carbon nanotube 30 and the substrate 10 may be between a few angstroms and 10 µm, more specifically between 1 nm and 5 µm. Different effects may result from variations in this distance. In particular, a large distance may exhibit advantages to prevent the influence of charge traps on the carbon nanotube 30. In other cases, bottom gates may be provided, in which case the separation may be adjusted so as to optimize control capabilities.

Similarly, the distance between the carbon nanotube 30 and the third electrodes 70, configured as top gates, may also be adjusted. Hence, in examples of the disclosure, the distance between the bottom part of the third electrodes 70 and the top part of the carbon nanotube may lie between a few angstroms and 1 µm, more specifically between 1 nm and 0.5 µm. This distance may depend on the intended application and the corresponding range of applied gate voltages. The distance may have an impact on the capacitive coupling between the carbon nanotube 30 and the third electrodes 70 and, consequently, it may influence the electrostatic field in the carbon nanotube 30. In examples, the electrostatic force induced by the capacitive coupling may result in some vibrations. Contact between the carbon nanotube 30 and the third electrodes 70, i.e. the top gates, may need to be avoided to prevent short circuiting of the device 1. In other words, the distance may be designed as a tradeoff between capacitive coupling and mitigation of risks associated to unwanted contact between the parts.

The first end of the carbon nanotube 30 may be embedded in the first electrode 50 and/or the second end of the carbon nanotube 30 may be embedded in the second electrode 60. In particular, Figure 1 shows an example wherein both ends of the carbon nanotube 30 may be embedded within the material used for the first electrode 50 and for the second electrode 60.

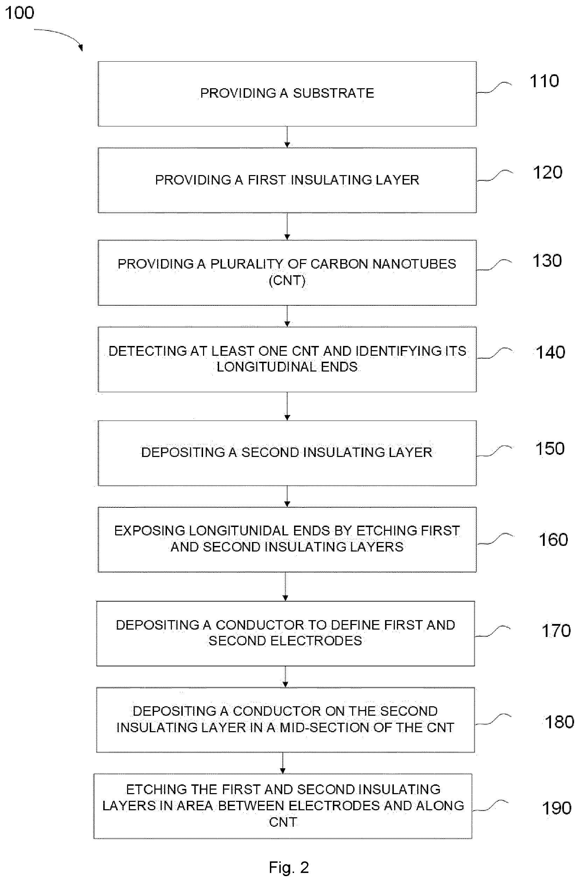

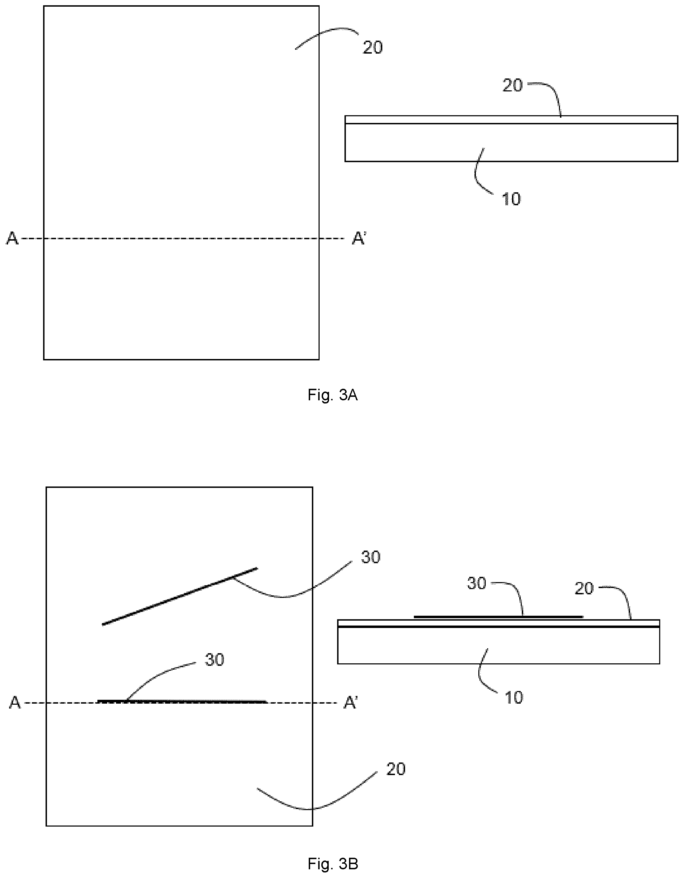

Electrical and mechanical contact between the ends of the carbon nanotube 30 and the first 50 and second 60 electrodes may be enhanced by embedding. In particular, the contact resistance between the carbon nanotube 30 and the respective first 50 and second 60 electrodes may be reduced with such an embedded arrangement when compared with other contact arrangements such as clamping. More details regarding the embedded contacts will be provided while discussing the manufacturing of the device 1 with respect to Figures 2 and Figures 3A-3G.

As known by those skilled in the art, carbon nanotubes CNT may exhibit different configurations. Specifically, CNTs can be single walled or multiple walled and they can exhibit different electronic character, e.g. metallic or semiconducting. In examples of the disclosure, the carbon nanotube 30 may be a single-walled carbon nanotube (SWCNT). More specifically, the carbon nanotube 30 may be a (narrow bandgap) semiconducting carbon nanotube 30.

Different materials may be used for the manufacture of the different elements of the device 1. Thus, in examples of the disclosure, at least one of Pd, Pt, Cr, Ti, Al or Au may be used for at least one of the first electrode 50, the second electrode 60, or the third electrode 70. Moreover, binary metals like TiN or TaN may also be used. In further examples, conductive carbon nanotubes (CNTs) or two dimensional conductors, e.g. graphene, may also be employed.

The selection of the material may be dependent on the materials having adequate electronic properties, e.g. work function, to enable a proper connection between the carbon nanotube 30 and the corresponding first 50 and second 60 electrodes. The application for the device 1 may influence the electronic properties of the carbon nanotube 30 selected for the device 1. These selection may, consequently, influence the required electronic properties of the materials used for the first 50 and second 60 electrodes. Furthermore, the selection of the material used for the third electrodes 70 may also be based on its mechanical properties, especially due to the hanging arrangement of a portion of the top gates.

In some examples, different materials may be employed for the first 50 and second 60 electrodes than for the third electrodes 70. In some further examples, the material used for the first electrode 50 may be different from the material used for the second electrode 60. In still further examples, a plurality of different materials may be used for a single electrode. Thus, a combination of, e.g. Cr/Au or Ti/Au, may be employed for the first 50 and/or the second 60 electrode to improve, e.g. adhesion or electronic properties.

Materials may be deposited by different semiconductor manufacturing techniques, including chemical vapor deposition (CVD), Atomic Layer Deposition (ALD), Physical Vapor Deposition (PVD) or ink-based additive methods.

As with the electrodes, different materials may be employed for the substrate 10 as well. Thus, in examples of the present disclosure, the substrate 10 of the device 1 may comprise one of a silicon, a sapphire, a diamond, a quartz or a borosilicate substrate.

The selection of the material for the substrate 10 may be dependent on different factors. Specifically, temperature requirements of the manufacturing process may be considered. In some examples, high temperatures (in the range of 900 - 1000°C) may be needed for the provision of the carbon nanotubes 30 on the substrate 10. In such examples, a substrate 10 capable of supporting such high temperatures may be needed.

Apart from the manufacturing process, the requirements of the application and the functionality of the device 1 may also determine the material of the substrate 10.

An example of a method to manufacture a device 1 according to the present disclosure will be now explained with reference to Figures 2 and 3A-3G. Figure 2 shows a flowchart of a method 100 of manufacturing a nanoelectromechanical device according to an example.

At block 110, the method comprises providing a substrate 10. A first insulating layer 20 is provided on the substrate 10 in block 120 of the method 100 whereas block 130 comprises providing a plurality of carbon nanotubes 30 (CNT) on the first insulating layer 20. Block 140 comprises detecting at least one carbon nanotube 30 of the plurality of carbon nanotubes 30 and identifying longitudinal ends of the detected carbon nanotube 30. A second insulating layer 40 is deposited on the first insulating layer 20 and at least on the detected carbon nanotube 30 in block 150. Block 160 comprises exposing the longitudinal ends of the detected carbon nanotube 30 by etching the first insulating layer 20 and the second insulating layer 40 in an area surrounding each of the longitudinal ends. Later on, in block 170, a conductor is deposited in the etched areas to define the first electrode 50 and the second electrode 60, such that the conductor contacts the longitudinal ends of the carbon nanotube. Block 180 of the method 100 comprises depositing a conductor on the second insulating layer 40 in a region overlapping the mid-section of the carbon nanotube 30 to form one or more third electrodes 70, which are configured as top gate structures. The first insulating layer 20 and the second insulating layer 40 are etched in block 190. In particular, they are etched in at least a portion of the area defined between the first electrode 50 and the second electrode 60 and along the length of the carbon nanotube 30.

Method 100 according to the flowchart in Figure 2 may result in a device 1 like the one depicted in Figure 1. In particular, the exposing of the longitudinal ends of the carbon nanotube 30 in block 160, followed by the deposition of a conductor in block 170, may result in an embedded contact, i.e. the ends of the carbon nanotube 30 may be embedded in the conductor material used for the first 50 and second 60 electrodes.

Even if a certain number of blocks are provided in method 100, it is understood that some examples may exist comprising additional blocks and/or altering the order of the previously presented blocks. As an example, two different sequences of block 160 and block 170 may be carried out, one for each of the first and second electrodes, in case the design of the device 1 comprises different materials for each of said.

Furthermore, a method according to a further example may comprise, after etching the first insulating layer 20 and the second insulating layer 40 in an area between the first electrode 50 and the second electrode 60 and along the length of the carbon nanotube 30, growing an oxide to wrap at least a mid-section of the carbon nanotube 30. According to this example, a device 1 comprising a more rigid carbon nanotube 30 may be manufactured. This may be desirable for some applications not relying on the flexural modes of the carbon nanotube 30. In this manner, influence of flexural modes may be prevented when operating the device 1 as, e.g. a spin qubit or a charge qubit. Different methods may be envisaged to deposit a coating material, e.g. an oxide, on the carbon nanotube 30. As an example, Atomic Layer Deposition (ALD) may be used to conformally deposit a thin coating material on the different surfaces of the device 1 and, particularly, to wrap a mid-section of the carbon nanotube 30.

Reference will now be made to Figures 3A-3G, which provide details of an example of a manufacturing method to obtain a device 1 like the one presented in Figure 1. In particular, Figures 3A - 3G schematically illustrate top and cross-sectional (A-A') views at different stages of an example method.

Figure 3A shows a first step in the example, which comprises the provision of a first insulating layer 20 on the substrate 10. As mentioned above, the present disclosure is not limited to any specific material for the substrate 10. Depending on the substrate 10 and on the intended application, different dielectric materials and different techniques may be employed for the provision of the first insulating layer 20. Thus, in some examples, a layer may be deposited by e.g. chemical vapor deposition (CVD), physical vapor deposition (PVD) or atomic layer deposition (ALD). In other examples comprising a silicon, Si, substrate, the first insulating layer 20 may be provided by thermal oxidation of the silicon, Si. Furthermore, in different variants of the example, the first insulating layer may comprise a nitride or a high-k material.

Figure 3B substantially corresponds to block 130 of the manufacturing method 100. As shown in the figure, a plurality of carbon nanotube 30 are provided on the first insulating layer 20. Only two carbon nanotubes 30 are shown in Figure 3B for illustration purposes. Different alternatives may be used for the provision of the carbon nanotubes 30. In an example of the disclosure, providing carbon nanotubes 30 on the first insulating layer 20 may comprise growing carbon nanotubes 30 directly on the first insulating layer 20. More specifically, the method may comprise growing carbon nanotubes 30 by means of Chemical Vapor Deposition (CVD).

In order to grow carbon nanotubes 30 on the first insulating layer 20 by means of CVD, a first step comprising the deposition of catalyst particles may be carried out. The specific locations of the catalyst particles may be defined by patterning with lithography, followed by deposition of a solution containing the catalysis particles. The solvent may subsequently be dried and the excess catalyst may be removed by the lift-off procedure. After formation of the catalyst particles on the surface of the first insulating layer 20, the substrate may be placed in a CVD reactor. The CVD process may use hydrogen (H₂), argon (Ar) and methane (CH₄), and the carbon nanotube growth process may be caried out at high temperatures in the range of 900°C. Based on the parameters of the process, carbon nanotubes 30 of different characteristics, e.g. length, may be obtained.

In other examples, the provision of carbon nanotubes 30 shown in Figure 3B may comprise depositing a solution with prefabricated carbon nanotubes 30 in a solvent and removing the solvent after the deposition.

By using a solution with prefabricated carbon nanotubes 30, process temperatures may be significantly lower than when using CVD, thus allowing the use of a larger variety of materials. More specifically, the avoidance of the high temperatures associated with the CVD process may allow the use of a wider range of materials for the substrates. Furthermore, the use of a solution of prefabricated carbon nanotubes may facilitate use of carbon nanotubes with predetermined characteristics. In particular, either metallic or semiconducting carbon nanotubes, or either single wall or multiple wall carbon nanotubes may be chosen for the fabrication of the device 1 depending on the intended application.

As shown in Figure 3B, the provided carbon nanotubes 30 are not necessarily arranged in an already known and predefined arrangement. This may be particularly the case when using the solution-based method for the provision of carbon nanotubes 30 which, in such case, they may be randomly distributed over the surface of the substrate 10. For this reason, before proceeding with the subsequent manufacturing steps, detection of the carbon nanotubes 30 and, more specifically, of the precise location of the ends of the carbon nanotubes 30 may be carried out. Thus, in an example of the disclosure, detecting at least one deposited carbon nanotube 30 and identifying longitudinal ends of the detected carbon nanotube 30 may comprise using optical methods for the detection of the deposited carbon nanotube and/or at least one of low power Scanning Electron Microscopy (SEM) and Atomic Force Microscopy (AFM) for identification of the longitudinal ends. In examples wherein the carbon nanotubes are grown in specific positions (rather than randomly distributed), prior knowledge regarding the positions of the nanotubes may be used when detecting them.

Detection of carbon nanotubes 30 and identification of the longitudinal ends of the carbon nanotube 30 may involve different methods and technologies depending on the characteristic, e.g. the size, of the carbon nanotubes 30. Thus, optical microscopes may be used for the detection and identification of the ends when considering long carbon nanotubes with e.g. longitudinal lengths exceeding 100 nanometers. To this end, advanced Deep Ultra Violet (DUV) optical systems may be employed. In other examples, a combination of optical detection means and more advanced scanning technologies may be employed. Specifically, optical microscopes may be used for the detection of carbon nanotubes 30 whereas a subsequent step comprising either Scanning Electron Microscopy (SEM) or Atomic Force Microscopy (AFM) may be utilized for the precise identification of the longitudinal ends.

In still further examples, specifically comprising very short carbon nanotubes 30, e.g. with lengths below 10-20 nm, direct observation with either SEM or AFM may be implemented. Markers may be defined on the surface of the substrate 10 to serve as a reference or guide to define and record the position of the identified carbon nanotubes 30. As an example, markers may be defined at certain locations of the substrate 10 by means of, e.g. photolithography or electron beam lithography.

In examples of the present disclosure, the detection of the carbon nanotubes 30 may be accompanied by a selection or test of the carbon nanotubes 30. In that manner, only carbon nanotubes 30 exhibiting the desired mechanical and/or electronic properties may be used for the manufacture of the device 1. Indeed, it is known that carbon nanotubes 30 can exhibit different electronic properties. More specifically, the bandgap of semiconducting carbon nanotubes 30 may also exhibit different values. Thus, narrow bandgap semiconducting carbon nanotubes 30 may be preferred for applications requiring tuning of tunnel barriers by means of electrostatic gates. In other cases, semiconducting carbon nanotubes 30 exhibiting larger bandgaps or carbon nanotubes exhibiting metallic electronic behavior may be preferred.

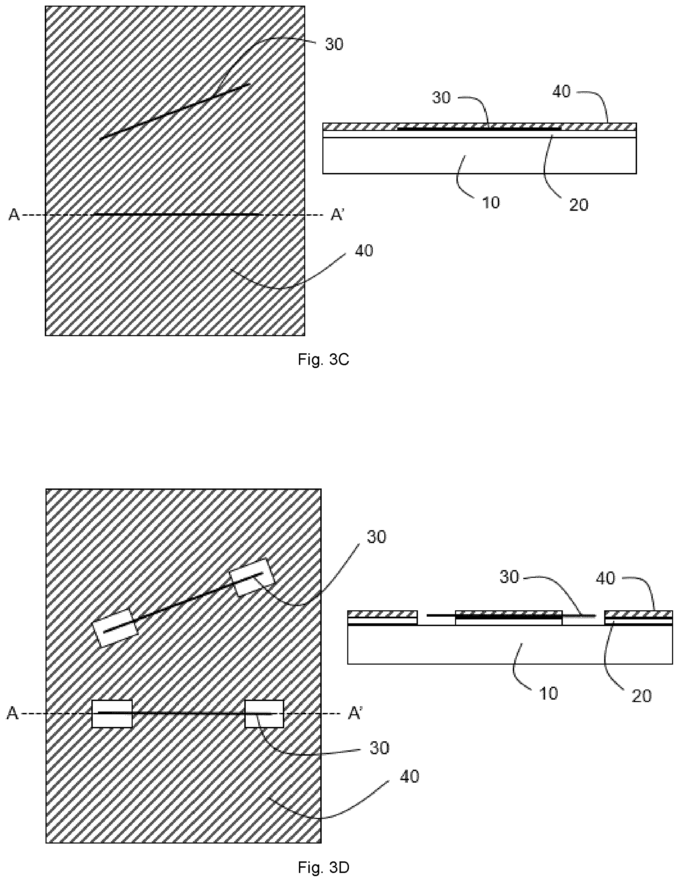

Figure 3C substantially corresponds to block 150 of the method 100, i.e. a second insulating layer 40 is deposited on the first insulating layer 20 and on at least one detected carbon nanotube 30. The same or different materials as those used for the first insulating layer 20 may be employed. Indeed, in examples of the present disclosure, at least one of the first insulating layer 20 and the second insulating layer 40 may comprise silicon dioxide, SiO₂, or a high-k material. Similar deposition techniques, e.g. CVD, PVD, ALD, as those already cited for the first insulating layer 20 may be employed for the second insulating layer 40.

Up to this stage of the manufacturing process, two insulating layers are provided on the substrate 10 and at least one carbon nanotube 30 is arranged in between the first insulating layer 20 and the second insulating layer 40. As shown in more detail below, the thickness of the first insulating layer 20 influences the separation between the carbon nanotube 30 and the substrate 10. Depending on the specific application, a certain separation may be needed. Similarly, the thickness of the second insulating layer 40 may define the separation between a top part of the carbon nanotube 30 and a bottom part of the third electrodes 70. This separation, and accordingly the thickness of the second insulating layer 40, may also be defined in accordance with the application of the device 1. In particular, the third electrodes 70, which are configured as top gates of the device 1, are capacitively coupled to the carbon nanotube 30. Accordingly, a relatively short distance may be needed to provide electrostatic coupling between the two components. Nevertheless, especially if mechanical, e.g. vibrational, properties of the carbon nanotube 30 are relevant for the specific application, a minimum separation, i.e. a minimum thickness of the second insulating layer 40, may also be specified.

Once the longitudinal ends of the carbon nanotube 30 are identified, next step comprises exposing said longitudinal ends by etching the first insulating layer 20 and the second insulating layer 40. Figure 3D schematically illustrates the stage of the manufacturing process after patterning and etching of the insulating layers. Thus, the longitudinal ends of the carbon nanotube 30 are exposed whereas the mid-section of the carbon nanotube 30 is sandwiched between the first insulating layer 20 and the second insulating layer 40.

Identification of the longitudinal ends of the carbon nanotube 30 may be used to generate the corresponding masks for lithography process based on location data of the longitudinal ends. Masks may be used for the etching of the first insulating layer 20 and the second insulating layer 40 at precise locations. Thus, etching of the first insulating layer 20 and the second insulating layer 40 may comprise lithography patterning. In other examples, patterning and etching of the first insulating layer 20 and the second insulating layer 40 may comprise using direct patterning techniques. For example, electron beam lithography (EBL), direct laser writing (DLP) or AFM lithography may be used.

Etching of the first 20 and second 40 insulating layers may be carried out while ensuring compatibility with the carbon nanotube 30. Indeed, it may be desirable that the longitudinal ends of the carbon nanotube 30 remain substantially unaffected during the etching process. Different etching alternatives may be used in examples of the disclosure. Diluted, i.e. wet, hydrofluoric acid, HF, may be used in an example. In other examples, etching the first insulating layer 20 and the second insulating layer 40 may comprise using a vapor or dry gas etching process. Specifically, etching may involve vapor phase HF etching or fluorinated gas-based plasma etching. Vapor etching or dry etching may be selected due to the lack of surface tension. This may facilitate etching of the insulating layers without substantially affecting the longitudinal ends of the carbon nanotube 30. Indeed, the longitudinal ends of the carbon nanotube 30 are left hanging in a cantilevered fashion during the etching so bending of the carbon nanotube 30 structure may arise. This bending may be reduced or even eliminated in examples using vapor or dry gas etching processes.

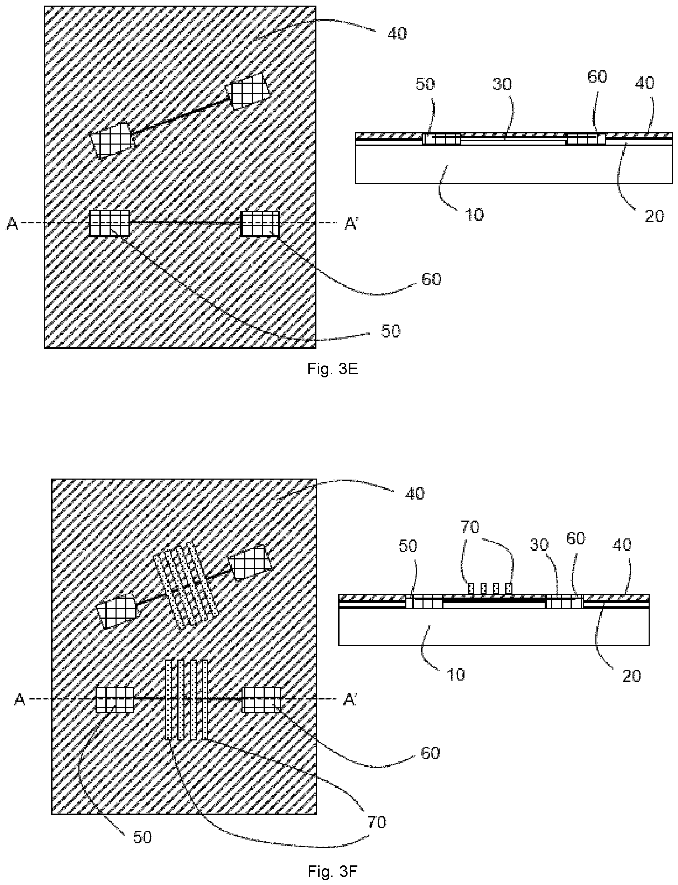

Etching of the first insulating layer 20 and the second insulating layer 40 creates the cavities or spaces for the definition of the first electrode 50 and the second electrode 60. Figure 3E depicts the stage of the manufacturing method after deposition of the conductor on the areas at both longitudinal ends of the carbon nanotube 30. As shown in the figure, both longitudinal ends of the carbon nanotube 30 are embedded in their respective conductor. Accordingly, a single step may be enough to embed the longitudinal ends. As mentioned before, providing embedded contacts between the longitudinal ends of the carbon nanotube 30 and the first 50 and second 60 electrodes may provide improved mechanical and electrical properties at the interfaces.

As mentioned above in reference to Figure 1, different materials may be used for the provision of the conductor for the first electrode 50 and the second electrodes 60. In an example of the disclosure, the material for the first electrode 50 and for the second electrode 60 may be deposited by standard semiconductor manufacturing techniques, including chemical vapor deposition (CVD), physical vapor deposition (PVD), atomic layer deposition (ALD) over the whole area of the substrate. After the deposition, a chemical mechanical planarization (CMP) process may be used to obtain a smooth surface and to remove unnecessary material. In other examples of the disclosure, photolithography or electron beam lithography may be used to selectively deposit the conductor material at the desired locations. Thus, the location data used for the etching of the first insulating layer 20 and the second insulating layer 40 may be used to selectively deposit the conductor material in the area for the first electrode 50 and for the second electrode 60 by means of lithography.

Previously mentioned examples may be used if the same material is used for both the first electrode 50 and the second electrode 60. Nevertheless, in still further examples, different conductor materials may be used for the first electrode 50 and for the second electrode 60. In this case, the sequence comprising the consecutive steps of etching the first 20 and second 40 insulating layers at the longitudinal ends of the carbon nanotube 30 (Figure 3D) and depositing the conductor for the electrodes 50, 60 (Figure 3E) may be carried out separately for each of the electrodes 50, 60. In other words, a first etching step may be carried out for the first electrode 50 and the material for the first electrode 50 may be deposited in the corresponding space corresponding to one of the ends of the carbon nanotube 30. Subsequently, the same steps may be repeated for the definition of the second electrode 60 at the other end of the carbon nanotube 30. Alternatively, the etching of the first insulating layer 20 and the second insulating layer 40 may be carried out in a single step and, subsequently, two separate photolithography steps may be carried out to obtain the first electrode 50 and the second electrode 60.

Referring again to the example in Figures 3A-3G, the next step in the manufacturing method is disclosed with reference to Figure 3F. Thus, after definition of the first electrode 50 and the second electrode 60, a plurality of third electrodes 70 is deposited on the second insulating layer 40. As shown in Figure 3F, a plurality of third electrodes 70, configured as top gates of the device 1, may be provided. The third electrodes 70 are arranged in an overlapping configuration with respect to the carbon nanotube 30, i.e. the third electrodes 70 are physically arranged above a mid-section of the carbon nanotube 30 and separated from the latter by the thickness of the second insulating layer 40. Similarly to the definition of the first electrode 50 and the second electrode 60, photolithography or electron beam lithography may be used to deposit the third electrodes 70. Previously generated location data may be used to accurately position the third electrodes 70 with respect to the carbon nanotube 30 and with respect to the first 50 and second 60 electrodes.

In the example depicted in Figure 3F, the third electrodes 70 are provided perpendicular to the longitudinal direction of the carbon nanotube 30. Other orientations may be used in alternative examples, provided the third electrodes 70, acting as top gates, are capacitively coupled to the carbon nanotube 30. In this manner, electrostatic potential at the carbon nanotube 30 may be locally controlled or electrostatic forces may be exerted by the third electrodes 70, i.e. by the top gates, to induce a vibration of the carbon nanotube 30. As mentioned above, different separations between the carbon nanotube 30 and the top gates may be preferred depending on the specific application of the device 1. To this end, different thicknesses for the second insulating layer 40 may be deposited. Apart from the separation between the carbon nanotube 30 and the third electrodes 70, other relevant parameters may also be adjusted in examples of the disclosure depending on the application. Thus, the number of third electrodes 70 and the separation between the third electrodes 70, i.e. the pitch, may also be adjusted.

Furthermore, the dimensions of individual third electrodes 70 may also be varied. More particularly, both the thickness and the width of the deposited third electrodes 70 may be selected so as to ensure proper mechanical stability.

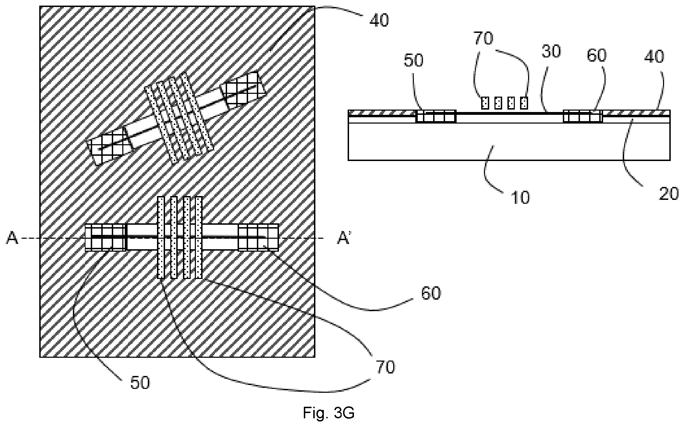

Figure 3G depicts the final stage of the manufacturing process. As shown in the figure, the material of the first insulating layer 20 and the second insulating layer 40 is removed, i.e. etched, in an area between the first electrode 50 and the second electrode 60 and along the carbon nanotube 30. In this manner, the carbon nanotube 30 becomes suspended or hanging, i.e. it is only contacted and supported at both ends whereas the mid-section of the carbon nanotube 30 is spaced apart from both the substrate 10 and the third electrodes 70. Thus, each of the third electrodes 70 may define a bridge-like structure. The ends of the third electrodes 70 may be supported on the second insulating layer 40 whereas an intermediate section of the third electrodes 70 crosses over the trench formed after the etching of the insulating layers. In other words, the third electrodes 70 are hanging between walls formed in the first 20 and the second 40 insulating layer. For this reason, dimensions of the third electrodes 70 and, more particularly, thickness of the metal deposition carried out for the definition of the third electrodes 70 may be adjusted to provide enough mechanical stability for such hanging structures.

Similarly to the etching step shown in reference to Figure 3D, a vapor or gas phase etching step may also be used in examples of the disclosure for the etching of the area between the first electrode 50 and the second electrode 60. Such gas phase etching may prevent surface tension that may otherwise result in bending of the carbon nanotube 30 and/or of the third electrodes 70.

In an example of the disclosure, not only the first insulating layer 20 and the second insulating layer 40 but also the substrate 10 may be etched. Thus, a method according to an example comprises etching the substrate 10 after etching the first 20 and the second 40 insulating layers for exposing the longitudinal ends of the detected carbon nanotube 30 and/or etching the substrate 10 after etching the first 20 and the second 40 insulating layers in the area between the first electrode 50 and the second electrode 60 and along the length of the carbon nanotube 30. In other words, the substrate 10 may be etched either after the situation depicted in Figure 3D or after the situation depicted in Figure 3G.

Thus, in examples of the disclosure, the substrate 10 itself may be selectively etched so as to adjust the performance and functionality of the device 1. More particularly, etching of the substrate 10 after patterning for the first electrode 50 and the second electrode 60, but before depositing the corresponding conductors (i.e. between the stages schematically depicted in Figures 3D and 3E), may be used to improve the mechanical and electrical connection between the longitudinal ends of the carbon nanotube 30 and the corresponding first 50 and second 60 electrodes. Similarly, the formation of a groove in the substrate 10 in the area for the first 50 and second 60 electrodes before deposition of the corresponding conductor material may also facilitate a proper definition and fixation of the electrodes 50, 60 on the substrate 10 as the first electrode 50 and the second electrode 60 may then become partially embedded in the substrate 10, thus improving the mechanical anchoring.

In another example of the disclosure, the substrate 10 may be etched at a later stage of the manufacturing process. In particular, the substrate 10 may be etched in the step defining the suspended carbon nanotube 30, i.e. after the stage presented in Figure 3F. In this manner, the distance between the mid-section of the carbon nanotube 30 and the substrate 10 may be enlarged while keeping the carbon nanotube 30 hanging from its longitudinal ends. In more general terms, the ability to etch the substrate 10 may provide additional flexibility in examples of the manufacturing process in order to better adjust the separation between the carbon nanotube 30 and the substrate 10. In an example, the substrate 10 may comprise a silicon, Si, substrate and XeF₂ vapor etching or dry etching with fluorinated gases may be used for the etching of the substrate.

In the previously described examples, devices 1 comprising only top gates have been considered. Nevertheless, in examples of the disclosure, the device 1 may comprise one or more bottom gates. Thus, apart from the third electrodes 70 defining one or more top gates, one or more bottom gates may be provided to enable a further degree of control of the device 1. Voltages of the one or more bottom gates may be adjusted independently from the voltages of the top gates. This may provide an additional parameter to control the electrostatic interaction with the carbon nanotube 30. Such additional level of control may be used in certain applications, such as when using the device 1 to define one or more quantum dots (QDs) in the carbon nanotube 30. Thus, both the top gates and the bottom gates may be used to tune the electronic properties of the one or more quantum dots.

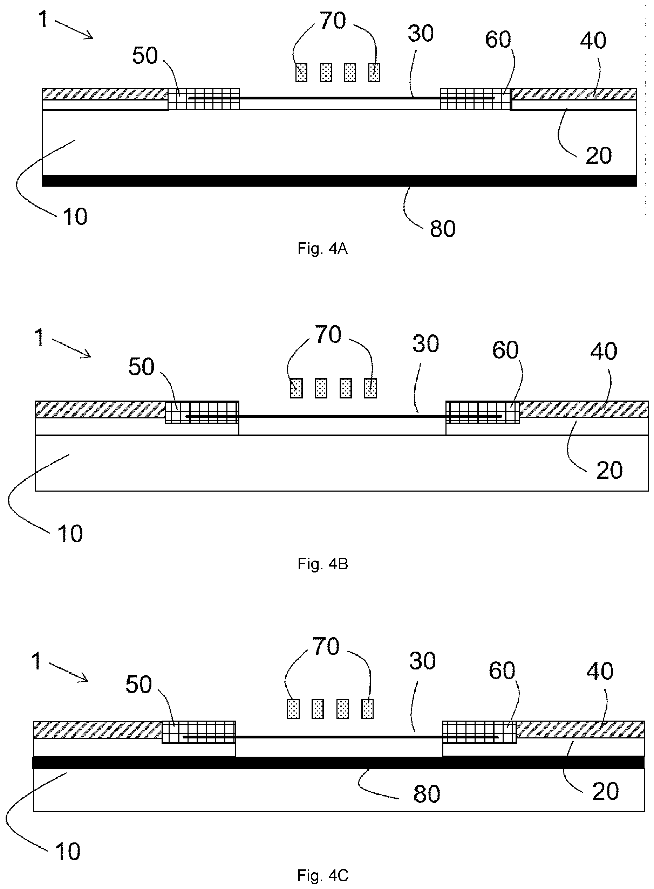

Different topologies may be used to provide the bottom gates as shown in Figures 4A - 4D. A first variant of a device 1, comprising a bottom gate, is schematically depicted in Figure 4A. In this example, the substrate 10 may comprise a top surface and a bottom surface, a first electrode 50, a second electrode 60 and a carbon nanotube 30 being arranged on the top surface. One or more fourth electrodes 80 (in the example of Figure 4A only one fourth electrode is included) may be defined on the bottom surface, the fourth electrodes 80 being configured as bottom gates. In this example, the single bottom gate may be arranged to offset the voltage over the whole structure of the device 1. In this example, the thickness of the substrate 10 may be in the range of a few to hundreds of nanometers and it may behave as a gate oxide.

Figure 4B schematically depicts a further variant of a device 1 comprising a bottom gate. In this example, a doped semiconductor, e.g. a doped silicon wafer, may be used as the substrate 10, which may then be biased with a voltage so that it may operate as a bottom gate or "body bias". In this example, an insulator 20 may be provided between the substrate 10 and the first 50 and second 60 electrodes. To this end, a similar process to the one described with reference to Figures 3A - 3G may be carried out. In particular, after deposition of the second insulating layer 40 (i.e. corresponding to Figure 3C), a pattering and etching step of the insulating layers 20, 40 may also be conducted to define an area for the first electrode 50 and the second electrode 60 (i.e. similarly to the step depicted in Figure 3D).

Nevertheless, in this example, at least a certain thickness of the first insulating layer 20 may be kept in the electrode area to prevent direct contact between the doped substrate 10 and the first 50 and second 60 electrodes. In other words, unlike in the example depicted in Figure 3D, in which the etching of the insulating layers 20, 40 may reach the surface of the substrate 10, a more carefully controlled etching process may be provided in this case. Thus, the etching time of the first 20 and second 40 insulating layers may be carefully adjusted to control the depth of the etching process so that the first insulating layer 20 may be only partially etched so as to keep a certain minimum distance between the doped substrate 10 and the electrodes 50, 60.

Subsequent steps, i.e. deposition of the conductor in the areas at both longitudinal ends of the carbon nanotube 30 to define the first electrode 50 and the second electrode 60, deposition of the third electrodes 70, and etching of the insulating layers 20, 40 in the area between the first electrode 50 and the second electrode 60 may be conducted in an equivalent manner as depicted in Figures 3E to 3G. As a result of this sequence of steps, a device 1 like the one depicted in Figure 4B may be obtained, in which the substrate 10 may act as a bottom gate to define a bias voltage whereas the ends of the carbon nanotube 30 may be embedded in the first 50 and second 60 electrodes while a mid-section of the carbon nanotube 30 may be suspended above the substrate 10.

Figure 4C shows still a further variant of a device 1 comprising a bottom gate. In this example, a substrate 10 comprising a top surface and a bottom surface may be provided. The device 1 may comprise a fourth electrode 80 arranged on the top surface of the substrate 10, the fourth electrode 80 being configured as a bottom gate. The device 1 may further comprise a first insulating layer 20 arranged between the fourth electrode 80 and the first 50 and second 60 electrodes so as to prevent contact between the fourth electrode 80 and any of the first 50 and second 60 electrodes. In this example, the fourth electrode 80 may be deposited before the corresponding step depicted in Figure 3A. Subsequently, similar steps to those described with regard to figures 3A-3G and with regard to the example of Figure 4B may be carried out. Thus, similarly to the previous example, direct contact between the fourth electrode 80 and any of the first electrode 50 and the second electrode 60 may be prevented by at least a certain thickness of the first insulating layer 20. Accordingly, a controlled etching of the insulating layers 20, 40 may be carried out so that the first insulating layer 20 may be only etched up to a certain depth.

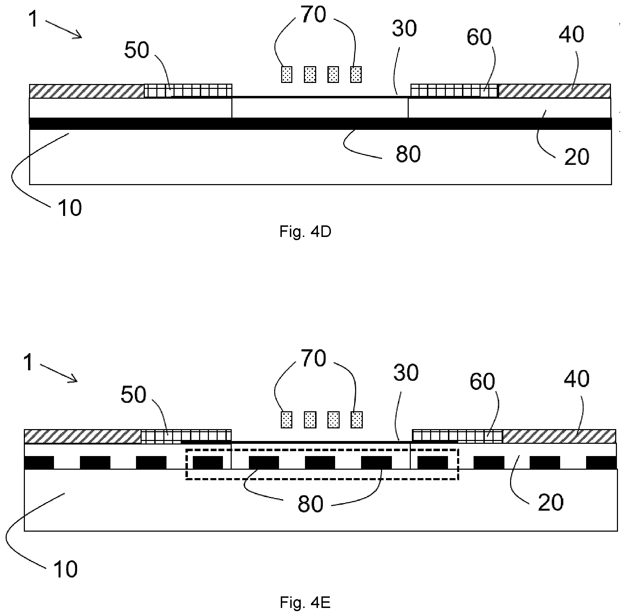

Another example of a device 1 comprising a bottom gate is depicted in Figure 4D. This example is similar to the one shown with reference to Figure 4C, as it also comprises a fourth electrode 80 deposited on the substrate 10. Nevertheless, in this variant, two different insulating materials may be used for the first insulating layer 20 and the second insulating layer 40. This may allow selective etching of the insulating layers 20. 40. Indeed, in this example, after depositing the second insulating layer 40, a patterning and etching step may be carried out to define the electrode areas by removing only the second insulating layer 40 while keeping the first insulating layer 20 substantially unaffected. Accordingly, the ends of the carbon nanotube 30 may be exposed and they may be contacted by the subsequent deposition of the conductor material for the first 50 and the second 60 electrodes. Finally, similarly to Figures 3F and 3G, third electrodes 70 may be deposited and an etching step, in this case etching both the first insulating layer 20 and the second insulating layer 40, may be conducted. On the one hand, this example may facilitate the manufacturing process. On the other hand, in this variant, the ends of the carbon nanotube 30 may not be fully embedded in the electrodes 50, 60 as schematically shown in Figure 4D.

It should be noted that the manufacturing method described with reference to Figure 4D, i.e. the manufacturing method comprising use of different materials for the first insulating layer 20 and the second insulating layer 40 with subsequent selective etching of only the second insulating layer 40, may also be applied in any of the previously shown examples. Specifically, said method may be applied to the other example devices 1 comprising bottom gates (depicted in Figures 4A-4C) and also to devices 1 comprising only top gates similar to those depicted in Figures 2 and 3A-3G. As indicated, the main difference when using this method is that the ends of the carbon nanotube 30 may not be embedded in the first 50 and second 60 electrodes.

In some other examples, a plurality of fourth electrodes 80 may be arranged at different positions along the length of the mid-section of the carbon nanotube 30 instead of having a single bottom fourth electrode 80 expanding over the whole area of the device 1. By providing a plurality of fourth electrodes 80, these may act as a plurality of bottom gates, which may facilitate selectively adjusting the voltage at specific portions of the device 1 by, e.g. coordinated actuation of the top and bottom gates. An example device 1 comprising a plurality of bottom gates is shown in Figure 4E. In particular, three fourth electrodes 80 are depicted in this example.

Different manufacturing methods may be used to provide such a plurality of fourth electrodes 80. Hence, in an example of the disclosure shown in Figure 4E, parallel strips of a conductive material may be pre-patterned on the substrate 10. Subsequentially, a first insulating layer 20 may be deposited in an equivalent manner as shown in Figure 3A. A plurality of carbon nanotubes 30 may then be provided on the first insulating layer 20 in an equivalent manner as shown in Figure 3B.

A step concerning detection and identification of carbon nanotubes 30 may also be provided in this example. Nevertheless, in this case, the identification of the carbon nanotubes 30 may also account for the relative position of the carbon nanotubes 30 with respect to the pre-patterned conductor strips. Accordingly, a carbon nanotube 30 may be selected which may be crossing a number of parallel strips, which would then be configured as bottom gates of the device 1. In the case of Figure 4E, a carbon nanotube 30 spanning over five such pre-patterned strips (see dashed rectangle) is depicted although only three of those pre-patterned strips are arranged in the portion of the carbon nanotube 30 intended for being suspended. The conductor strips at the ends of the dashed rectangle are in the region intended for the first 50 and second 60 electrodes.

After selection of the carbon nanotube 30, a second insulating layer 40 may be deposited in an equivalent manner as shown in Figure 3C. Subsequently, a similar process for the definition of the first 50, second 60 and third 70 electrodes to the one described while referring to Figures 4B-4D may be caried out. In particular, a controlled etching of the first 20 and second 40 insulating layers may be implemented for the definition of the areas for first 50 and second 60 electrodes to prevent potential short circuit between any of the first 50 and second 60 electrodes and the pre-patterned strips, i.e. with the strips at the ends of the dashed rectangle which may overlap with the areas of the corresponding first 50 and second 60 electrodes.

In the example depicted in Figure 4E, an equivalent solution to the one described with reference to Figure 4D may be implemented although a solution like the one explained with reference to Figures 4C and 4C may also be used. Thus, a selective etching of the second insulating layer 40 may be carried out while leaving the first insulating layer 20 substantially unaffected during the process step for definition of the first 50 and second 60 electrode areas. Subsequentially, an etching step comprising etching of the first 20 and second 40 insulating layer while leaving the conductor material of the fourth electrodes 80 substantially unaffected may be carried out in an equivalent manner as described with reference to Figure 3G to leave a suspended carbon nanotube 30 which, in this case, may be capacitively coupled to both the third electrodes 70 and the fourth electrodes 80.

In an example of the disclosure, an arrangement like the one schematically depicted in Figure 4E may allow a larger separation among the third electrodes 70, which may be useful to prevent capacitive coupling between the top gates.

Apart from top gates and bottom gates, the device 1 may further comprise one or more side gates (not shown in Figure 1) arranged at one or both sides of the carbon nanotube 30 in examples of the disclosure.

Side gates may be provided for different purposes depending on the application of the device 1. Thus, in some examples, side gates may be arranged at a short distance from the carbon nanotube 30 so as to enable capacitive coupling between the side gates and the carbon nanotube 30. In this manner, side gates may be used as electrostatic gates to e.g. fine-tune the electrostatic potential and/or to induce electrostatic forces at certain locations of the carbon nanotube 30.

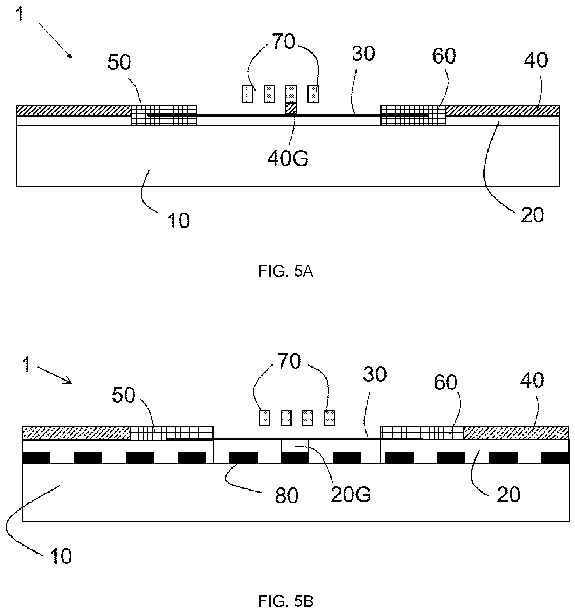

Examples described in relation to previous figures comprise devices 1 wherein a carbon nanotube 30 is fully suspended, i.e. the whole mid-section of the carbon nanotube 30 is spaced above the substrate 10. Furthermore, previous examples referred to devices 1 wherein an empty space exists between a top part of the carbon nanotube 30 and all the third electrodes 70 or top gates. Nevertheless, examples of devices 1 wherein a physical contact is established with the carbon nanotube 30 may also be considered by the present disclosure. Figures 5A and 5B schematically depict two such examples.

Figure 5A schematically discloses a device 1 that shares many similarities with the device shown in relation to Figure 1. Nevertheless, in this example, an insulator 40G is disposed between a top part of the carbon nanotube 30 and a bottom part of one of the third electrodes 70 acting as top gates. More particularly, the insulator 40G may be configured as a gate oxide for the corresponding top gate. The insulator 40G may correspond to a portion of the second insulating layer 40, disposed in the area wherein the corresponding third electrode 70 overlaps the carbon nanotube 30. Photolithography or electron beam lithography steps, together with selective etching processes, may be carried out. Thus, similar processes and techniques to those described for the previous examples may be used so no further details are deemed necessary.

In a variant of this example, not only the insulator 40G, but also a portion (not shown in Figure 5A) of the first insulating layer 20, may be provided in the region underneath the insulator 40G. This may be beneficial for manufacturing and/or for functionality purposes.

The provision of a physical contact with the carbon nanotube 30 at one or more locations along the length of the mid-section may be useful when using the device 1 as a nanomechanical system. Thus, the flexural modes of the carbon nanotube 30 may be split. In particular, as shown in Figure 5A, a single insulator 40G may be arranged to enable physical contact with only one of the third electrodes 70. Consequently, the flexural modes of the carbon nanotube 30 may be split in two. In other examples, further splitting of the flexural modes of the carbon nanotube 30 may be enabled by splitting the mid-section of the carbon nanotube 30 into more sections by enabling more third electrodes 70 (i.e. top gates) to establish a physical contact with the carbon nanotube via corresponding gate oxides.

A similar concept is shown in the example of Figure 5B. In this device 1, which resembles the device described in relation to Figure 4E, both third electrodes 70 and fourth electrodes 80 may be defined and configured as, respectively, top gates and bottom gates of the device 1. In this example, an insulator 20G may be used to define a physical contact between one of the fourth electrodes 80 and the carbon nanotube 30. In this case, the insulator 20G may correspond to a portion of the first insulating layer 20. Similarly to the example in Figure 5A, the insulator 20G may act as a gate oxide for the corresponding bottom gate. Manufacturing of this device 1 may also comprise similar steps and similar techniques as those already described so no further details will be provided.

The example of Figure 5B may offer similar technical advantages to the one depicted with reference to Figure 5A. Thus, the provision of such a contact, may act as a split point for the mid-section of the carbon nanotube 30, which may allow splitting the flexural modes of the carbon nanotube 30. Such splitting may be useful when employing the device 1 as a nanomechanical device.

In further variants, the examples of Figures 5A and 5B may be combined, i.e. insulators or gate oxides may be provided for one or more third electrodes 70 acting as top gates and for one or more fourth electrodes 80 acting as bottom gates. In this manner, physical contacts with the carbon nanotube 30 may be provided from both types of gates.

For reasons of completeness, various aspects of the present disclosure are set out in the following numbered clauses:
Clause 1. A device, comprising:
   a substrate;
   a first electrode on the substrate and configured as either a source or a drain of the device;
   a second electrode on the substrate configured as the other of the source and the drain of the device;
   a carbon nanotube with a first end connected to the first electrode and a second end connected to the second electrode, at least a portion of a mid-section of the carbon nanotube being suspended above a surface of the substrate;
   one or more third electrodes arranged above the carbon nanotube and configured as top gates capacitively coupled to the carbon nanotube; wherein an empty space exists between a top part of the carbon nanotube and a bottom part of at least one of the third electrodes.
Clause 2. The device of clause 1, wherein the carbon nanotube extends substantially along a longitudinal direction from the first electrode to the second electrode, the device comprising a plurality of third electrodes arranged above the carbon nanotube and configured as a plurality of top gates, the third electrodes being arranged at different positions along the longitudinal direction and along the mid-section of the carbon nanotube.
Clause 3. The device of clause 2, comprising three or more third electrodes, more specifically, comprising five third electrodes.
Clause 4. The device of any previous clause, wherein the whole mid-section of the carbon nanotube is suspended above a surface of the substrate.
Clause 5. The device of any previous clause, wherein an empty space exists between a top part of the carbon nanotube and a bottom part of all the third electrodes.
Clause 6. The device of any of clauses 1 to 4, wherein an insulator, more specifically an oxide, is provided in the space existing between a top part of the carbon nanotube and the bottom part of at least one of the third electrodes so that a physical contact is established.
Clause 7. The device of any previous clause, further comprising a coating material, specifically an oxide, arranged wrapping the mid-section of the carbon nanotube.
Clause 8. The device of any previous clause, wherein multiple carbon nanotubes are arranged in parallel and connected between the first electrode and the second electrode, the mid-section of the multiple carbon nanotubes being suspended above a surface of the substrate.
Clause 9. The device of any previous clause, wherein the device comprises one or more bottom gates.
Clause 10. The device of clause 8, wherein the substrate comprises a top surface and a bottom surface, the first electrode, second electrode and carbon nanotube being arranged on the top surface and one or more fourth electrodes being defined on the bottom surface, the fourth electrodes being configured as the bottom gates.
Clause 11. The device of clause 8, wherein the substrate comprises a top surface and a bottom surface, the device comprising a fourth electrode arranged on the top surface of the substrate and being configured as the bottom gate, and the device further comprising a first insulating layer arranged between the fourth electrode and the first and second electrodes so as to prevent contact between the fourth electrode and any of the first and second electrodes.
Clause 12. The device of any previous clause, the device further comprising one or more side gates arranged at one or both sides of the carbon nanotube.
Clause 13. The device of any previous clause, wherein the third electrodes have a thickness of between 1 nm and 100 µm and a width of between 1nm and 10 µm.
Clause 14. The device of any previous clause, wherein the distance between the first electrode and the second electrode lies between 3 nm and 100 µm.
Clause 15. The device of any previous clause, wherein the distance between the at least portion of the mid-section that is suspended above the substrate and the substrate lies between a few angstroms and 10 µm, more specifically between 1 nm and 5 µm.
Clause 16. The device of any previous clause, wherein the distance between the top part of the carbon nanotube and the bottom part of the at least one of the third electrodes for which an empty space exists lies between a few angstroms and 1 µm, more specifically between 1 nm and 0.5 µm.
Clause 17. The device of any previous clause, wherein the first end of the carbon nanotube is embedded in the first electrode and/or the second end of the carbon nanotube is embedded in the second electrode.
Clause 18. The device of any previous clause, wherein the carbon nanotube is a single wall carbon nanotube (SWCNT), more specifically, wherein the carbon nanotube is a semiconducting carbon nanotube.
Clause 19. The device of any previous clause, wherein at least one of the following: Pd, Pt, Cr, Ti, Al, Au, a binary metal like TiN or TaN, or a two-dimensional conductor like graphene, is used for at least one of the first electrode, the second electrode or the third electrode.
Clause 20. The device of any previous clause, wherein the substrate comprises one of a silicon, a sapphire, a diamond, a quartz or a borosilicate substrate.
Clause 21. A method of manufacturing a device according to any of clauses 1 to 20, the method comprising:
   - providing the substrate;
   - providing a first insulating layer on the substrate;
   - providing a plurality of carbon nanotubes on the first insulating layer;
   - detecting at least one carbon nanotube of the plurality of carbon nanotubes and identifying longitudinal ends of the detected carbon nanotube;
   - depositing a second insulating layer on the first insulating layer and at least on the detected carbon nanotube;
   - exposing the longitudinal ends of the detected carbon nanotube by etching the first and the second insulating layers in an area surrounding each of the longitudinal ends;
   - depositing a conductor in the etched areas to define the first electrode and the second electrode, the conductor contacting the longitudinal ends of the carbon nanotube;
   - depositing a conductor on the second insulating layer in a region overlapping the mid-section of the carbon nanotube to form the one or more third electrodes configured as top gates structures;
   - etching the first insulating layer and the second insulating layer in at least a portion of an area between the first electrode and the second electrode and along the length of the carbon nanotube.
Clause 22. The method of clause 21, further comprising, after etching the first insulating layer and the second insulating layer in at least a portion of an area between the first electrode and the second electrode and along the length of the carbon nanotube, growing an oxide to wrap at least a mid-section of the carbon nanotube.
Clause 23. The method of any of clauses 21 or 22, wherein providing carbon nanotubes on the first insulating layer comprises growing carbon nanotubes directly on the first insulating layer, more specifically, growing carbon nanotubes by means of Chemical Vapor Deposition (CVD).
Clause 24. The method of any of clauses 21 or 22, wherein providing carbon nanotubes on the first insulating layer comprises depositing a solution with prefabricated carbon nanotubes in a solvent and removing the solvent after the deposition.
Clause 25. The method of any of clauses 21 to 25, wherein detecting at least one deposited carbon nanotube and identifying longitudinal ends of the detected carbon nanotube comprises using optical methods for the detection of the deposited carbon nanotube and/or low power Scanning Electron Microscopy (SEM) or Atomic Force Microscopy (AFM) for identification of the longitudinal ends.
Clause 26. The method of any of clauses 21 to 25, wherein etching the first and second insulating layers comprises using a vapor or dry gas etching process.
Clause 27. The method of any of clauses 21 to 26, wherein patterning and etching of the first insulating layer and the second insulating layer comprises using direct write techniques, specifically using electron beam lithography or direct laser writing.
Clause 28. The method of any of clauses 21 to 27, wherein the substrate is etched after etching the first and the second insulating layers for exposing the longitudinal ends of the detected carbon nanotube and/or wherein the substrate is etched after etching the first and the second insulating layers in the area between the first electrode and the second electrode and along the length of the carbon nanotube.
Clause 29. The method of clause 28, wherein the substrate comprises a silicon, Si, substrate and XeF₂ vapor etching or dry etching with fluorinated gases is used.
Clause 30. The method of any of clauses 21 to 29, wherein at least one of the first and second insulating layers comprises silicon oxide, SiO₂, or a high-k material.

This written description uses examples to disclose the teaching, including the preferred embodiments, and also to enable any person skilled in the art to practice the teaching, including making and using any devices or systems and performing any incorporated methods. The patentable scope is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims. Aspects from the various embodiments described, as well as other known equivalents for each such aspects, can be mixed and matched by one of ordinary skill in the art to construct additional embodiments and techniques in accordance with principles of this application. If reference signs related to drawings are placed in parentheses in a claim, they are solely for attempting to increase the intelligibility of the claim, and shall not be construed as limiting the scope of the claim.

## Claims

1. A device, comprising:
a substrate;
a first electrode on the substrate and configured as either a source or a drain of the device;
a second electrode on the substrate configured as the other of the source and the drain of the device;
a carbon nanotube with a first end connected to the first electrode and a second end connected to the second electrode, at least a portion of a mid-section of the carbon nanotube being suspended above a surface of the substrate;
one or more third electrodes arranged above the carbon nanotube and configured as top gates capacitively coupled to the carbon nanotube; wherein
an empty space exists between a top part of the carbon nanotube and a bottom part of one or more of the third electrodes.

2. The device of claim 1, wherein the carbon nanotube extends substantially along a longitudinal direction from the first electrode to the second electrode, the device comprising a plurality of third electrodes arranged above the carbon nanotube and configured as a plurality of top gates, the third electrodes being arranged at different positions along the longitudinal direction and along the mid-section of the carbon nanotube.

3. The device of any of claims 1 or 2, further comprising a coating material, specifically an oxide, wrapping at least a portion of the mid-section of the carbon nanotube.

4. The device of any of claims 1 to 3, wherein the device comprises one or more bottom gates.

5. The device of claim 4, wherein the substrate comprises a top surface and a bottom surface, the first electrode, second electrode and carbon nanotube being arranged on the top surface and one or more fourth electrodes being defined on the bottom surface, the fourth electrodes being configured as the bottom gates.

6. The device of claim 4, wherein the substrate comprises a top surface and a bottom surface, the device comprising a fourth electrode arranged on the top surface of the substrate and being configured as the bottom gate, and the device further comprising a first insulating layer arranged between the fourth electrode and the first and second electrodes so as to prevent contact between the fourth electrode and any of the first and second electrodes.

7. The device of any of claims 1 - 6, the device further comprising one or more side gates arranged at one or both sides of the carbon nanotube.

8. The device of any of claims 1 - 7 wherein the first end of the carbon nanotube is embedded in the first electrode and/or the second end of the carbon nanotube is embedded in the second electrode.

9. A method of manufacturing a device according to any of claims 1 to 8, the method comprising:
providing the substrate;
providing a first insulating layer on the substrate;
providing a plurality of carbon nanotubes on the first insulating layer;
detecting at least one carbon nanotube of the plurality of carbon nanotubes and identifying longitudinal ends of the detected carbon nanotube;
depositing a second insulating layer on the first insulating layer and at least on the detected carbon nanotube;
exposing the longitudinal ends of the detected carbon nanotube by etching the first and the second insulating layers in an area surrounding each of the longitudinal ends;
depositing a conductor in the etched areas to define the first electrode and the second electrode, the conductor contacting the longitudinal ends of the carbon nanotube;
depositing a conductor on the second insulating layer in a region overlapping the mid-section of the carbon nanotube to form the one or more third electrodes configured as top gates structures;
etching the first insulating layer and the second insulating layer in at least a portion of an area between the first electrode and the second electrode and along the length of the carbon nanotube.

10. The method of any of claim 9, further comprising, after etching the first insulating layer and the second insulating layer in at least a portion of an area between the first electrode and the second electrode and along the length of the carbon nanotube, growing an oxide to wrap at least a portion of a mid-section of the carbon nanotube.

11. The method of any of claims 9 or 10, wherein providing carbon nanotubes on the first insulating layer comprises growing carbon nanotubes directly on the first insulating layer, more specifically, growing carbon nanotubes by means of Chemical Vapor Deposition (CVD).

12. The method of any of claims 9 or 10, wherein providing carbon nanotubes on the first insulating layer comprises depositing a solution with prefabricated carbon nanotubes in a solvent and removing the solvent after the deposition.

13. The method of any of claims 9 to 12, wherein detecting at least one deposited carbon nanotube and identifying longitudinal ends of the detected carbon nanotube comprises using optical methods for the detection of the deposited carbon nanotube and/or at least one of low power Scanning Electron Microscopy (SEM) and Atomic Force Microscopy (AFM) for identification of the longitudinal ends.

14. The method of any of claims 9 to 13, wherein etching the first and second insulating layers comprises using a vapor or dry gas etching process.

15. The method of any of claims 9 to 14, wherein the substrate is etched after etching the first and the second insulating layers for exposing the longitudinal ends of the detected carbon nanotube and/or wherein the substrate is etched after etching the first and the second insulating layers in the area between the first electrode and the second electrode and along the length of the carbon nanotube.
